# EUROPEAN PATENT SPECIFICATION

(11) **EP 2 587 899 B1**
(45) Date of publication and mention of the grant of the patent: **27.05.2015**
(21) Application number: 12190163.1
(22) Date of filing: 26.10.2012
(51) Int. Cl.: H05K 1/09, H01B 1/22, H01B 1/02, H01B 1/16, B22F 9/24, B22F 1/00, B22F 3/10, C22C 1/04, C22C 9/00, H05K 3/32

(54) **Sinterable bonding material using copper nanoparticles, process for producing same, and method of bonding electronic component**
Sinterbares Klebematerial mit Kupfernanopartikeln, Herstellungsverfahren dafür und Verfahren zum Kleben elektronischer Komponenten
Matériau de liaison frittable à l'aide de nanoparticules de cuivre, son procédé de production et procédé de soudage de composant électronique

(30) Priority: 27.10.2011 JP 2011235605
(43) Date of publication of application: 01.05.2013
(73) Proprietor: Hitachi, Ltd., Tokyo 100-8280 (JP)
(72) Inventor: Yasuda, Yusuke, Tokyo, 100-8220 (JP); Morita, Toshiaki, Tokyo, 100-8220 (JP); Kobayashi, Yoshio, Ibaraki, 316-8511 (JP)
(74) Representative: MERH-IP Matias Erny Reichl Hoffmann

(56) References cited:
- US-A- 5 180 523
- US-A1- 2004 221 685
- US-A1- 2006 236 813
- US-A1- 2008 160 183
- US-A1- 2010 009 071
- US-B1- 6 391 087

## Description

### TECHNICAL FIELD:

The present invention concerns a sinterable bonding material using copper nanoparticles, a process for producing the same, and a method of bonding electronic components by using the sinterable bonding material. "

### BACKGROUND ART:

Since metal nanoparticles (having a particle diameter of 100 nm or less, for example) have a large specific surface area relative to the volume of a particle, they have high chemical activity and have extremely low sintering temperature. Due to the property, the metal nanoparticles have attracted attention as a novel functional material. For example, a paste containing the metal nanoparticles is expected as a material used for bonding electronic components to each other disposed inside electronics and formation of circuit wirings.

It has been found recently that low temperature bondability with dissimilar metals is improved extremely as the particle diameter of the metal nanoparticle decreases further (for example, to a particle diameter of 35 nm or less). For using the metal nanoparticles in the application of electronics, metal nanoparticles having high thermal conductivity, electric conductivity and heat resistance (oxidation resistance) are generallypreferred. Therefore,nanoparticlesof noble metalssuch as gold or silver have been often used and relatively inexpensive silver has been used frequently among them.

However, silver involves a drawback of tending to cause ion migration which tends to cause short-circuit.

For suppressing the ionmigration, use of copper nanoparticles is effective. Further, copper has a thermal conductivity about equal with that of silver (silver: 430 W/m•K, copper: 400 W/m•K) and is much more advantageous than silver in view of the cost.

As a process for producing the copper nanoparticles, it has been reported that a process for producing copper nanoparticles having a particle diameter of 10 nm or less by using CTAB (cetyl trimethyl ammoniumbromine) as a dispersant, for example, by Szu-Han Wu and Dong-Hwang Chen, in Journal of Colloid and Interface Science, 273(2004), pp. 165-169 (Non-Patent Document 1). However, the copper nanoparticles have to be cleaned before a sintering heat treatment in order to remove excessive CTAB.

However, cleaning of the copper nanoparticles involves a problem that metallic copper is oxidized into cuprous oxide. Once the metallic copper is oxidized into cuprous oxide, sintering in atmospheric air becomes difficult. And also heating at 400°C or higher is necessary even in a reducing atmosphere such as hydrogen atmosphere. Therefore, low temperature sintering per se is difficult.

For example, Japanese Unexamined Patent Application Publication Nos. 2005-60779 (Patent Document 1) and 2005-60778 (Patent Document 2) disclose copper powders improved in oxidation resistance by coating the surface of copper particles with a silicone oil containing at least one functional group selected from mercapto group, amino group, amide group, etc., and copper pastes or copper coating materials blended with the copper powders.

Japanese Unexamined Patent Application Publication No. 2007-258123 (Patent Document 3) discloses an electroconductive composition containing a mixture of a copper powder having an average particle diameter of 0. 3 to 20 µm and a fine copper powder having an average particle diameter of 1 to 50 nm, a solvent, and an additive for dissolving an oxide formed on the surface of the copper powder, which enables low temperature sintering in atmospheric air and prevents oxidation of copper particles.

Japanese Unexamined Patent Application Publication No. 2011-094223 (Patent Document 4) discloses a bonding agent for inorganic materials, the bonding agent being a paste including colloidal metal particles and a solvent, the colloidal metal particles made of metal nanoparticles and a dispersant, the metal nanoparticles having a number average particle diameter of 50 nm or less and a particle diameter of 100 to 200 nm. Further, Patent Document 4 discloses that the metal nanoparticles may be copper nanoparticles, the specific surface area of the metal powder is preferably 0.1 to 5 m²/g, and the ratio of the dispersant can be selected from a range of about 0.01 to 15 mass parts as a solid content based on 100 mass parts of the metal nanoparticles.

It is considered that the copper powders described in Patent Document 1 and Patent Document 2 are excellent in the oxidation resistance, but it may be a possibility that the residue of the silicone oil tends to be left in the bonded portion upon sintering heat treatment in a narrow space for such an application as bonding electronic components to each other, thereby deteriorating the bonding strength or thermal conductivity.

Further, the electroconductive composition described in Patent Document 3 causes adsorption of the solvent and the additive to the surface of the produced fine copper powder by using a ball mill or the like. The electroconductive composition may have difficulties in uniform coating to the nanoparticles having a particle diameter of 100 nm or less, and suppression of oxidization of the nanoparticles.

For the metal particles described in Patent Document 4, an antioxidant should be added depending on the case since the particle diameter and the specific surface area are not selected with a view point of the oxidation resistance of copper as a sort of constituent metal.

Document US 2006/236813 A1 discloses a sinterable material comprising copper nanoparticles having a particle diameter of 1000nm or less. The copper nanoparticles include primary particles and secondary particles.

Document US 2008/160183 A1 discloses a semiconductor device comprising a connection terminal including copper, a semiconductor element having an electrode, and a bonding layer including copper nanoparticles disposed between the terminal and the electrode.

In this context, also documents US 2004/221685 A1, US 6,391,087 B1, US 2010/009071 A1 and US 5,180,523 A should be mentioned.

The present invention intends to render the oxidation resistance and the bondability of the sinterable bonding material using copper nanoparticles compatible to each other and suppress ion migration in the bonded portion of a semiconductor device, etc. manufactured by using the sinterable bonding material.

### SUMMARY OF THE INVENTION:

The present invention provides a sinterable bonding material according to claim 1 which is a liquid or a paste containing copper nanoparticles having a particle diameter of 1,000 nm or less, in which the copper nanoparticles have one or more particle diameter peaks of a number-based grain size distribution within a class of particle diameter of 1 to 35 nm and within a class of particle diameter of more than 35 nm and 1, 000 nm or less respectively, and/or in which the copper nanoparticles include primary particles and secondary particles, each of the secondary particles being a fused body of the primary particles.

According to the present invention, the oxidation resistance and the bondability of the sinterable bonding material using the copper nanoparticles can be rendered compatible and ion migration in the bonding portion of a semiconductor device or the like manufactured by using the sinterable bonding material can be suppressed.

### BRIEF DESCRIPTION OF THE DRAWINGS:

Fig. 1 is a flow chart showing production steps of copper nanoparticles in a preferred embodiment;
Fig. 2A is a TEM image of the copper nanoparticles in the preferred embodiment;
Fig. 2B is a schematic view illustrating an agglomeration state of the copper nanoparticles in the preferred embodiment;
Fig. 2C is a schematic view illustrating a fused state of the copper nanoparticles in the preferred embodiment;
Fig. 3A is a graph showing the particle diameter distribution (number distribution) of copper nanoparticles in a preferred embodiment (specimen 1);
Fig. 3B is a graph showing the particle diameter distribution (number distribution) of copper nanoparticles in the preferred embodiment (specimen 2);
Fig. 4 is a graph showing a relation between a particle diameter and a specific surface area;
Fig. 5 is a graph showing a relation between the specific surface area and a bonding strength of copper nanoparticles of the preferred embodiment;
Fig. 6 is a schematic cross-sectional view illustrating an example of a wiring substrate and a pin fin cooling unit used in a semiconductor power module;
Fig. 7A is a plan view illustrating an insulated type semiconductor device;
Fig. 7B is a cross-sectional view along line A-A in Fig. 7A;
Fig. 8 is a perspective view illustrating the insulation type semiconductor device in Fig. 7A;
Fig. 9 is an enlarged cross-sectional view illustrating a portion of disposing the semiconductor device in Fig. 8;
Fig. 10A is a cross-sectional view illustrating a capacitor used for a built-in type multilayer wiring substrate;
Fig. 10B is a cross-sectional view illustrating a LSI chip used for a part built-in type multilayer wiring substrate;
Fig. 10C is a cross-sectional view illustrating a core layer used for a part built-in type multilayer wiring substrate;
Fig. 11 is a cross-sectional view illustrating an example of a part built-in type multilayer wiring substrate;
Fig. 12 is a cross-sectional view illustrating another example of a part built-in type multilayer wiring substrate;
Fig. 13 is a cross-sectional view illustrating another example of a part built-in type multilayer wiring substrate;
Fig. 14 is a cross-sectional view illustrating an example of a stacked chip; and
Fig. 15 is an SEM image of a bonding layer in the preferred embodiment.

### DETAILED DESCRIPTION OF THE PREFERRED EMBODIMENTS:

The present invention concerns a sinterable bonding material used for bonding electronic components to each other and forming circuit wirings, and it particularly relates to a sinterable bonding material of high thermal conductivity mainly including copper nanoparticles, a production process thereof, and a method of bonding electronic components by using the sinterable bonding material. In the present specification, a semiconductor device, a circuit substrate, etc. are collectively referred to as "electronic component".

The following materials, methods and devices are to be described hereinafter:
They are a sinterable bonding material, a production process thereof, a method of bonding electronic components by using the sinterable bonding material, and a semiconductor device using the sinterable bonding material according to preferred embodiments of the present invention.

The sinterable bonding material is a liquid or a paste containing copper nanoparticles having a particle diameter of 1, 000 nm or less, in which one or more particle diameter peaks of a number-based particle diameter distribution of the copper nanoparticles are present within a class of the particle diameter of 1 to 35 nm and within a class of a particle diameter of more than 35 nm and 1,000 nm or less respectively, and the copper nanoparticles include primary particles and secondary particles each as a fused body of the primary particles.

In the sinterable bonding material, the copper nanoparticles have a specific surface area of 3 to 10 m²/g. The copper nanoparticles are preferably dispersed in a liquid or a paste.

In the sinterable bonding material, the liquid is preferably water or a mixed solution of water and an alcoholic solvent.

In the sinterable bonding material, the content of the copper nanoparticles is preferably 80 mass% or more.

Further, the sinterable bonding material preferably contains a dispersion stabilizer.

In the sinterable bonding material, the content of the dispersion stabilizer is preferably 30 mass parts or less based on 100 mass parts of copper that constitutes the copper nanoparticles.

In the sinterable bonding material, the dispersion stabilizer preferably is sodium dodecyl sulfate, cetyl trimethyl ammonium chloride, citric acid, ethylenediamine tetraacetic acid, sodium bis(2-ethylhexyl) sulfonate, cetyl trimethyl ammonium bromide, polyvinyl pyrrolidone, polyacrylic acid, polyvinyl alcohol, or polyethylene glycol.

The process for producing the sinterable bonding material which is a liquid containing copper nanoparticles having a particle diameter of 1, 000 nm or less, the copper nanoparticles having one or more particle diameter peaks of a number-based particle diameter distribution within a class of a particle diameter of 1 to 35 nm and within a class of a particle diameter of more than 35 nm and 1,000 nm or less respectively, having the specific surface area of 3 to 10 m²/g, and being dispersed in the liquid includes the steps of: dissolving a copper compound in a liquid to form copper ions first; adding an alkaline solution while flowing an inert gas in a liquid containing copper ions thereby forming a colloidal cupric oxide second; adding a dispersion stabilizer to the liquid third; and adding a reducing agent in a state of mixing the dispersion stabilizer in the liquid containing the colloidal cupric oxide, thereby forming the copper nanoparticles.

In the process for producing the sinterable bonding material, the copper compound includes preferably at least one of cupric nitrate hydrate, cupric oxide and cupric carboxylate.

The process for producing the sinterable bonding material preferably includes the steps of: drying the liquid containing the copper nanoparticles; and then dispersing the copper nanoparticles in a dispersion medium into a pasty form.

The method of bonding the electronic components includes the steps of: coating the sinterable bonding material on one surface or both surfaces of a portion to be bonded; and applying a sintering heat treatment at 100 to 500°C in a reducing atmosphere upon bonding a plurality of electronic components.

In the method of bonding the electronic components, it is preferred to use a reducing atmosphere that enables sintering at a low temperature and can proceed the reducing reaction sufficiently even at the low temperature thereby obtaining a sufficient bonding strength. Specifically, a reducing atmosphere of tending to proceed the reducing reaction at 200°C or lower is preferred. More specifically, an atmosphere of hydrogen, formic acid, acetic acid or ethanol is preferred with the reason described above.

In the method of bonding the electronic components, it is preferred to apply a sintering heat treatment while pressing the electronic components in a direction of the bonding.

In the method of bonding the electronic components, the electronic components are preferably a chip and a wiring substrate of a semiconductor device.

In the method of bonding the electronic components, the electronic components are preferably cooling fins and a metal support plate of a cooling unit.

The semiconductor device includes a connection terminal formed of copper or a copper alloy and a semiconductor element having electrodes, in which the surface of the electrode is coated with a nickel plating layer, a bonding layer made of a sinterable bonding material containing copper nanoparticleshaving a particle diameter of 1,000 nm or less is provided between the connection terminal and the electrode, the sinterable bonding material has one or more particle diameter peaks of a number-based particle diameter distribution of the copper nanoparticles within a class of the particle diameter of 1 to 35 nm and within a class of the particle diameter of more than 35 nm and 1,000 nm or less respectively, and the copper nanoparticles include primary particles and secondary particles each as a fused body of the primary particles.

In the semiconductor device, the bonding layer preferably has a porous structure and has a bonding strength of 25 MPa or more.

Preferred embodiments of the present invention are to be described with reference to the drawings along with production procedures of the sinterable bonding material. However, the present invention is not restricted to the preferred embodiments described herein and appropriate combinations or improvements are possible within the scope defined by the appended claims.

### (Production process for sinterable bonding material)

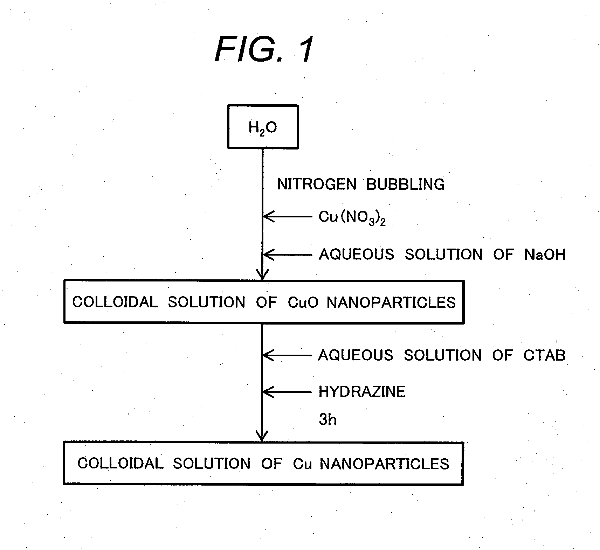

Fig. 1 is a flow chart showing an example of a process for producing copper nanoparticles.

At first, as a solvent for producing cupric oxide nanoparticle (CuO nanoparticle), a distilled water subjected to inert gas bubbling under stirring for 30 minutes or more is provided. The inert gas bubbling is performed in order to remove dissolved oxygen in the solvent and prevent formation of impurities other than cupric oxide during reaction. Any inert gas may be used so long as the reaction of copper ions to other materials than cupric oxide in the solution is suppressed, and includes a nitrogen gas, an argon gas and a helium gas, for example. In the example shown in the drawing, a nitrogen gas was used.

The inert gas bubbling is preferably continued till the completion of the reaction of forming the cupric oxide. Further, a flow rate of the bubbling particularly in a range from 1 mL/min to 1,000 mL/min is suitable. The reaction does not proceed uniformly because the reaction system becomes not homogeneous if the flow rate is more than 1,000 mL/min. On the other hand, the dissolved oxygen cannot be removed sufficiently if the flow rate is less than 1 mL/min.

Then, a powder of a copper compound as the starting material is dissolved while stirring the solvent controlled to a temperature of 5°C to 90°C to formcopper ions. The copper compound as the starting material is preferably a compound capable of decreasing the residues derived from anions upon dissolution and, for example, cupric nitrate trihydrate, cupric chloride, cupric hydroxide, and cupric acetate as a cupric carboxylate can be used preferably. Among them, cupric nitrate trihydrateisparticularly preferredsince the amount of impurities formed upon forming the cupric oxide is decreased. Further, when the cupric nitrate trihydrate is used, spherical CuO tends to be formed. Since subsequent reducing reaction proceeds more easily when CuO is spherical CuO compared with the case of acicular CuO, more preferred sinterable bonding material can be obtained when the cupric nitrate trihydrate is used.

The concentration of the copper compound solution is preferably at a copper concentration of 0.001 to 1 mol/L and particularly preferably 0.010 mol/L. A concentration of less than 0.001 mol/L is excessively thin and not preferred since yield of cupric oxide is lowered. Further, a concentration exceeding 1 mol/L is not preferred since uniform reaction is difficult and stable cupric oxide nanoparticles are not formed.

The temperature of the solvent is defined as 5°C to 90°C by the following reason.

Since the solvent mainly including water is used in this production process, when the solvent temperature (reaction temperature) exceeds 90°C, nanoparticles having desired size or shape cannot be obtained. Further, the solvent temperature (reaction temperature) of lower than 5°C is not preferred since aimed cupric oxide is less formed to lower the yield. As a more preferred condition, the solvent temperature (reaction temperature) is in a range from 20°C to 90°C. This is because nanoparticles having desired size and shape can be obtained in a range of the solvent temperature (reaction temperature) of 5°C to 90°C but impurities tend to remain at 20°C or lower.

Then, colloidal cupric oxide nanoparticles are formed by adding an alkaline solution. As the alkaline solution to be added, potassium hydroxide (KOH), barium hydroxide (Ba(OH)₂), sodium carbonate (Na₂CO₃), calcium hydroxide (Ca(OH)₂), sodium hydroxide (NaOH), and the like are used suitably. Among them, NaOH and KOH are particularly preferred. This is because NaOH and KOH contain less impurity and form less byproducts or impurities upon reaction.

The amount of the alkaline solution to be added is such that the ratio [OH⁻]/[Cu²⁺] of the molar concentration of alkali ions [OH⁻] (mol/L) to the molar concentration of cupric ions [Cu²⁺] (mol/L) is 1.5 or more and less than 2.1. When "[OH⁻] / [Cu²⁺]" is 2.1 or more, the shape of the formed secondary particles of the cupric oxide is deteriorated and the fused body of the copper nanoparticles is less formed upon subsequent reduction with hydrazine to lower the bonding strength.

Further, "[OH⁻]/[Cu²⁺]" of less than 1.5 is not preferred since the cupric oxide per se is less formed. When the concentration is described as "1.5 or more and less than 2.1" this represents a range of 1.5 to 2.1 with 2.1 being excluded from the range in the present specification.

The reaction time is not particularly restricted and the reaction is performed preferably in a range from 1 minute to 336 hours (14 days). Since the reaction is not completed within the reaction time of less than 1 minute, the yield is lowered. On the other hand, longer reaction time is wasteful since the reaction is completed within 336 hours at the latest.

By the steps described above, a colloidal solution of CuO nanoparticles is obtained.

Then, the CuO nanoparticles prepared in the steps described above are reduced to copper nanoparticles (Cu nanoparticle).

The step is performed by adding hydrazine as a reducing agent in the presence of a dispersion stabilizer.

As the reducing agent, any material capable of reducing the copper ions in the solution may be used, and includes boron hydride, hypophosphite, etc. in addition to hydrazine described above. The reason why the use of hydrazine is preferred is that residues are not formed after reaction with the cupric compound, the safety is relatively high, and handling is easy.

As the dispersion stabilizer (dispersant), a dispersant giving less effect upon sintering bonding (causing less residues) and, specifically, a dispersant having a decomposing temperature of 300°C or lower is preferred. When a dispersant having a decomposing temperature of 300°C or higher is used, more residues are formed in the bonding layer to result in lowering of the bonding strength. More specifically, the dispersant includes sodium dodecyl sulfate, cetyl trimethyl ammonium chloride (CTAC), citric acid, ethylenediamine tetraacetic acid, sodium bis(2-ethylhexyl)sulfonate (AOT), cetyl trimethyl ammonium bromide (CTAB), polyvinyl pyrrolidone, polyacrylic acid, polyvinyl alcohol, polyethylene glycol, etc.

The dispersant may be mixed to such an extent as improving the dispersibility of the nanoparticles and it is suitable that the dispersant is 30 mass parts or less based on 100 mass parts of copper. If more amount of the dispersant is added, residues tend to remain in the bonding layer and cause lowering of the bonding strength. The lower limit of the dispersant is 1 mass part based on 100 mass parts of copper. When the amount of the dispersant is less than the lower limit, nanoparticles are agglomerated and no sufficient bonding strength can be obtained.

The reaction time in this step also has no particular restriction and the reaction is preferably performed in a range of 1 minute to 336 hours (14 days). If the reaction time is 1 minute or less, the yield is lowered since the reaction is not completed. On the other hand, longer reaction time is wasteful since the reaction is completed within 336 hours at the latest. Further, for proceeding the reaction more rapidly and sufficiently, the reaction time is preferably 12 hours, or more preferably 24 hours or more, while this depends on the temperature condition.

By the steps described above, a colloidal solution of the Cu nanoparticles is obtained.

As described above, while solvent mainly including water is used in the production process, the reaction rate and the diameter of primary particles can be controlled by the mixing of a polar organic solvent. As the polar organic solvent, alcohols (for example, ethanol, methanol, isopropyl alcohol and 2-ethylhexyl alcohol, ethylene glycol, triethylene glycol, ethylene glycol monobutyl ether, etc.), aldehydes (for example, acetaldehyde), and polyols (for example, glycol) can be used suitably. The mixing ratio of water and the polar organic solvent is optional. Together with the addition of the polar organic solvent, a non-polar organic solvent (for example, ketones such as acetone, tetrahydrofurane, N,N-dimethylformamide, toluene, hexane, cyclohexane, xylene, and benzene) may also be added.

The colloidal solution of the Cu nanoparticles may be used as it is as the sinterable bonding material but centrifugal cleaning is preferably performed by 1 to 10 times after the reaction since unreacted products, byproducts formed upon reaction, anions, etc. still remain in the solution. Thus, the unreacted products, byproducts formed upon reaction, anions, etc. can be removed. As the cleaning solution, water, polar organic solvent, or a mixture thereof described above can be used preferably.

They are preferably dispersed in an appropriate liquid (dispersion medium) to prepare a paste-like sintering bonding material after drying the copper nanoparticles obtained by centrifugal cleaning as described above. In this case, the content of the copper nanoparticles in the sinterable bonding material is preferably 80 mass% or more with a view point of the bonding strength. This is because the viscosity is lowered to deteriorate the feedability if the content is less than 80 mass% when the particles are formed into a paste shape. Also, this is because sufficient bonding strength is difficult to be obtained with a view point of the bonding strength. The content of the copper nanoparticles is more preferably 90 mass% ormorewithaviewpoint of further improving the bonding strength. As the dispersion medium, water or the polar organic solvent, or the mixture thereof (mixed solvent) described above can be used preferably. Alternatively, the non-polar organic solvent may also be added to the polar organic solvent or the mixture of water and the polar organic solvent (solvent mixture).

Method of determining of the dispersion stabilizer contained in the sinterable bonding material includes dispersing the sinterable bonding material in water, alcohol, etc. and analyzing them by GC/MS. This is because organic materials contained in the dispersion stabilizer and materials having the structure derived therefrom are detected by using GC/MS.

### (Property of sinterable bonding material)

In the present invention, it is essential that the sinterable bonding material includes primary particles having a particle diameter of 1 to 35 nm and secondary particles each as a fused body of the primary particles having a particle diameter of more than 35 nm and 1,000 nm or less, and that the specific surface area of the entire particles of the primary particles and the secondary particles in total is in a range of 3 to 10 m²/g. The specific surface area for the entire particles is referred to herein as "specific surface area of copper nanoparticles".

If the sinterable bonding material only consists of the primary particles having the particle diameter of 1 to 35 nm, the specific surface area is increased and the particles are tended to be oxidized entirely.

On the contrary, when the particles of a smaller specific surface area than that of the primary particles, having the particle diameter of more than 35 nm and 1,000 nm or less are present in admixture, thereby decreasing the specific surface area of the entire particles of the primary particles and the secondary particles in total, oxidation for the particles can be suppressed entirely. The particle diameter is defined as more than 35 nm and 1, 000 nm or less because the surface activity is higher and particles tend to be oxidized if the particle diameter is 35 nm or less. Further, this is because sintering and bonding between the particles to each other is difficult at low temperature if the particle diameter is larger than 1,000 nm.

In the sinterable bonding material of the present invention, particles having a particle diameter of more than 35 nm and 1, 000 nm or less are formed by agglomeration and fusion of the primary particles having the particle diameter of 1 to 35 nm. This is because the effect of lowering the specific surface area of the entire particles is obtained when the particles having a particle diameter of 1 to 35 nm are agglomerated and fused.

When the target of bonding is copper which is identical with copper nanoparticles that constitute the sinterable bonding material of the present invention, bonding at a low temperature region is possible even when particles having a particle diameter of 1 to 35 nm are not present. On the other hand, when bonding with a dissimilar metal (for example, Au, Ag or Ni) is performed at low temperature, particles having a particle diameter of 1 to 35 nm are necessary. If the particle diameter is less than 1 nm, the chemical activity at the surface is higher and particles are easily agglomerated also at a room temperature. Thus, control of the specific surface area for the entire particles is difficult. Further, if the particle diameter is more than 35 nm, bonding with the dissimilar metal at low temperature is difficult. It is not always necessary that the shape of the particle that constitutes the sinterable bonding material is a spherical shape, but it may be an ellipsoidal shape or a polyhedral shape.

A more preferred range of the particle diameter is 1 to 20 nm. A particularly preferred range of the particle diameter is 1 to 10 nm. This is because the temperature for attaining a desired bonding strength with a dissimilar metal can be lowered further as the particle diameter is smaller.

In summary, primary particles having a particle diameter of 1 to 35 nm are necessary for attaining the bonding with the dissimilar metal at low temperature. On the other hand, particles having a particle diameter of more than 35 nm and 1, 000 nm or less are necessary for improving the oxidation resistance.

The fused particle body including copper nanoparticles having a particle diameter of 35 nm or less and particles having a particle diameter of more than 35 nm and 1,000 nm or less can be observed by using an electron microscope (for example, transmission electron microscope). For the particle size distribution, actually measured values can be obtained from those observed under the electron microscope. Further, particle size distribution can also be measured by using a particle size analyzer or the like. The particle size distribution is to be described in the subsequent examples with reference to actually measured data.

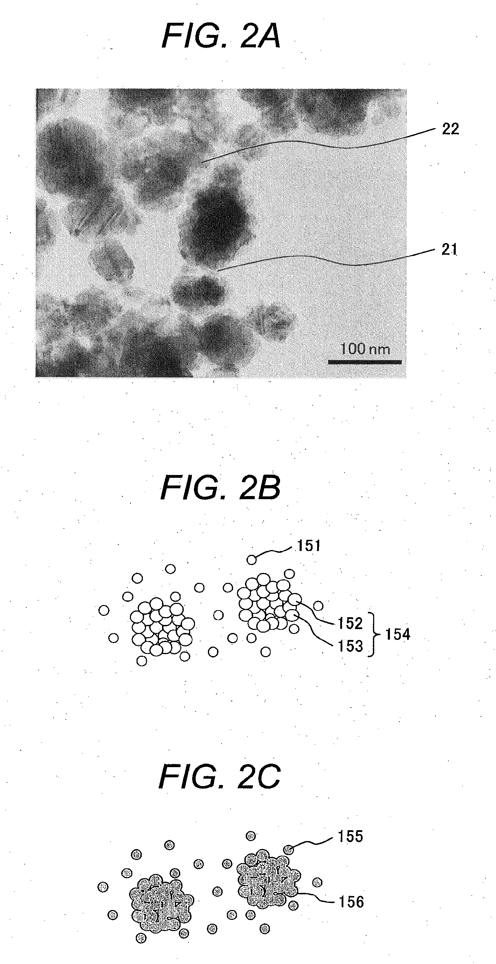

Fig. 2A is an image showing the result of observation on copper nanoparticles contained in the sinterable bonding material by a transmission electron microscope (TEM).

In view of the image, it can be seen that (copper nanoparticle single body) as primary particles and fused particles 22 (copper nanoparticle fused body) formed by combination of individual particles 21 are contained in the sinterable bonding material.

Fig. 2B shows an agglomeration state of the copper nanoparticles. Further, Fig. 2C shows a fused state of the copper nanoparticles.

Fig. 2B shows individual particles 151 and agglomeration bodies 154 (secondary particles) of individual particles 152, 153. That is, Fig. 2B shows a state in which the copper nanoparticles formed by the reaction are agglomerated and a state before fusion of the agglomerated individual particle 151 of the copper nanoparticles.

. Further, Fig. 2C shows individual particles 155 (primary particles) and fused bodies 156 of the individual particles. That is, Fig. 2C shows a state after fusion of the copper nanoparticles agglomerated as shown in Fig. 2B. As shown in Fig. 2C, the fused body is formed by metal bonding of the individual particles 155 to each other which is different from the agglomeratedbody. Further, the fused body 156 is a sort of the secondary particles.

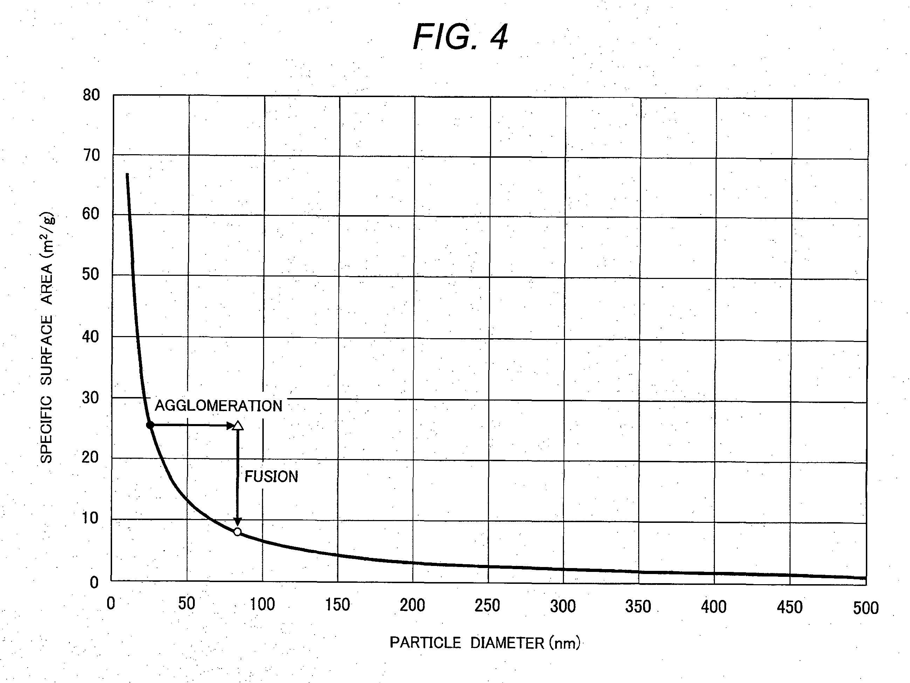

Fig. 4 is a graph showing a relationbetween a particle diameter and a specific surface area. The abscissa shows the particle diameter and the ordinate shows the specific surface area. The graph shows theoretical values when the particle diameter is constant and has no distribution.

From the graph, it can be seen that the specific surface area increases abruptly as the particle diameter decreases. For example, the specific surface area is 6.7 m²/g when the particle diameter is 100 nm, the specific surface area is 13.5 m²/g when the particle diameter is 50 nm, the specific surface area is 19.6 m²/g when the particle diameter is 35 nm, and the specific surface area is 33.6 m²/g when the particle diameter is 20 nm.

Generally, since the surface free energy of a substance is an amount of energy per unit area, as the particle diameter decreases and the specific surface area increases, the surface free energy per unit volume increases to increase the surface activity. Thus, the copper nanoparticles tend to be bonded also with dissimilar metal at low temperature. In other words, bonding is possible at lower temperature as the particle diameter decreases and the specific surface area increases.

As shown in Fig. 2B and Fig. 2C, the formed copper nanoparticles are completed by way of the process of agglomeration and fusion. In the process, formation of the second particles along with agglomeration, that is, increase in the apparent particle diameter proceeds as a first stage, as shown in Fig. 4. Then, fusion of the primary particles that constitute the secondary particles precedes and the specific surface area decreases as a second stage. In Fig. 4, change of the particle diameter in the process is shown as the change from "●" to "Δ" and change of the specific surface area is shown as the change from "Δ" to "○"

### (Sintering heat treatment)

A sintering heat treatment to the sinterable bonding material is preferably performed in a reducing atmosphere at a temperature of 100 to 500°C. While the reducing atmosphere is not particularly restricted, a hydrogen atmosphere, a formic acid atmosphere, an ethanol atmosphere, or the like is preferred.

The present invention is to be described specifically with reference to preferred embodiments. However, the present invention is not restricted to the description of them.

### [Example 1]

### (Preparation of copper nanoparticles)

As a starting compound for copper, a powder of Cu (NO₃)₂•3H₂O was used, water was used as a solvent. NaOH was used as a precipitating agent of cupric oxide nanoparticles. 1.932 g of a powder of Cu(NO₃)₂•3H₂O was added to 784.8 mL of distilled water subjected to nitrogen bubbling for 30 minutes in a beaker of 1, 000 mL volume, and the powder was dissolved uniformly in a water bath at 20°C and 80°C. Then, by dropping 15.2 mL of a 1.0 Maqueous solution of NaOH, a colloidal liquid dispersion of cupric oxide nanoparticles was prepared.

Then, after stirring the colloidal liquid dispersion of cupric oxide nanoparticles at a room temperature for 24 hours, 1.82 g of CTAB was dissolved in 190.3 mL of water, to which 9.7 mL of hydrazine was dropped to prepare a colloidal liquid dispersion of copper nanoparticles.

The obtained copper nanoparticles were subjected to centrifugal separation (centrifugal cleaning machine, Suprema 21 manufactured by Tomy Seiko Co., Ltd.) and cleaning operation each by three times. Then, the copper nanoparticles were taken out and dried to obtain 0.5 g of copper nanoparticles (specimens 1 to 2).

Table 1 shows specimens 1 to 2 and Comparative Examples 1 to 3 to be described later collectively.

"Reaction temperature" shown in the table is a temperature upon forming cupric oxide nanoparticles.

In the case of specimens 1 to 2, it can be seen that a specific surface area was 3 to 10 m²/g, and particle diameter peaks in the number-based particle diameter distribution of copper nanoparticles are present each by one within a class interval of the particle diameter of 1 to 35 nm and within a class of the particle diameter of more than 35 nm and 1,000 nm or less respectively, as shown in this table. Further, the bonding strength was higher than that of Comparative Examples 1 to 3 and it was 40 MPa or more.

**[Table 1]**

| Specimen | Example | | Comp. Example 1 | Comp. Example 2 | Comp. Example 3 |
|---|---|---|---|---|---|
| | Specimen 1 | Specimen 2 | Non-Patent Document 1 | Aldrich | Wako Pure Chemical |
| Reaction temperature | 20 | 80 | Room temperature | - | - |
| Specific surface area (m²/g) | 6.5 | 4.1 | 11 | 13.45 | 0.64 |
| Cupric oxide | absent | absent | present | present | absent |
| Particle diameter peak (nm) | 30 | 30 | 20 | 50 | 1000 |
| | 61 | 40, 62 | | | |
| Bonding strength (MPa) | 41.8 | 44.2 | 10 | 11 | 6 |

### (Property of copper nanoparticle)

For the prepared copper nanoparticles (specimens 1 to 2), particle size was measured based the image obtained by using a transmission electron microscope (JEM-2000FX II manufactured by JEOL Ltd.)

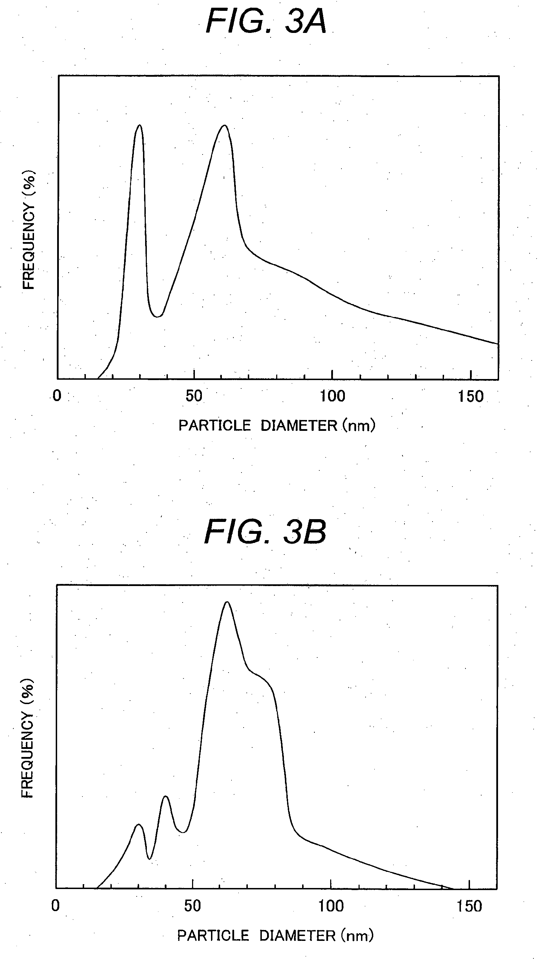

Fig. 3A is a graph showing a particle diameter distribution of copper nanoparticles (number distribution) of the example (specimen 1). Fig. 3B is a graph showing a particle diameter distribution of copper nanoparticles (number distribution) of the example the (specimen 2). "Number distribution" is also referred to as a "number-based particle diameter distribution". The total number of particles as a target for measuring the frequency of the particle diameter is about 50 and the class interval of the particle diameter for measurement of the respective frequencies is 1 nm. The particle diameter for each of the particles is the maximum size in the horizontal direction of each of the particles in the image.

It can be seen in view of Fig. 3A that there are two particle diameters at maximal frequency in the specimen 1 and they are 30 nm and 61 nm.

Further, it can be seen in view of Fig. 3B that there are three particle diameters at maximal frequency in the specimen 2 and they are 30 nm, 40 nm and 62 nm.

The particle diameter at maximal frequency is referred to herein as "particle diameter peak".

Further, the oxidized state of the particles was confirmed by using the X-ray diffraction apparatus (RU200B manufactured by Rigaku Corporation). Further, the specific surface area of particles was measured by using a BET automatic specific surface area measuring apparatus (Mascsorb model HM-1201 manufactured by Mountech Co., Ltd.).

Table 1 shows the property of the primary particles in the specimens 1 and 2 and Comparative Examples 1 to 3.

The copper nanoparticles of Comparative Example 1 were prepared by the method described in Non-Patent Document 1. The copper nanoparticles of Comparative Example 2 were purchased from Aldrich Co. The copper particles of Comparative Example 3 were purchased from Wako Pure Chemical Industry Co.

### (State of formation of oxide to the specific surface area of copper nanoparticles)

As shown in Table 1, peaks of cupric oxide did not appear in the XRD diffraction pattern of the copper nanoparticles in the specimens 1 to 2 (particles prepared at a reaction temperature of 20°C and 80°C) . On the other hand, peaks of cupric oxide were observed in the particles of Comparative Examples 1 and 2. This is because the specific surface area of the particles of the specimens 1 to 2 was as small as 4.1 to 6.5 m²/g, whereas the specific surface area of Comparative Example 1 and 2 was as large as 11 m²/g and 13.45 m²/g.

In view of the above, it was found that oxidation of the copper nanoparticles tends to proceed easily when the specific surface area is 11 m²/g or more. This is considered to be attributable to that the surface activity is higher as the specific surface area is larger.

### [Example 2]

### (Bonding strength test on sinterable bonding material)

Abonding strength test was performed while simulating bonding between electronic components to each other. The test method is as shown below.

As a copper specimen for measurement, a lower test specimen of 10 mm diameter and 5 mm thickness and an upper test specimen of 5 mm diameter and 2 mm thickness were used. The sinterable bonding material was coated on the upper surface of the lower test specimen and dried at 80°C under a reduced pressure for one hour. Subsequently, the upper test specimen was placed over the dried sinterable bonding material. A sintering heat treatment was performed in hydrogen at a temperature of 400°C for 5 minutes while simultaneously applying a load at a surface pressure of 1.2 MPa to obtain a bonded test specimen.

A shear stress was loaded on the bonded test specimen by using a shear tester (Bond tester SS-100KP, maximum load 100 kg, manufactured by Nissin Shoji Co.) (shear rate: 30 mm/min), and maximum load at break was measured. The bonding strength was determined by dividing the maximum load by a bonding area.

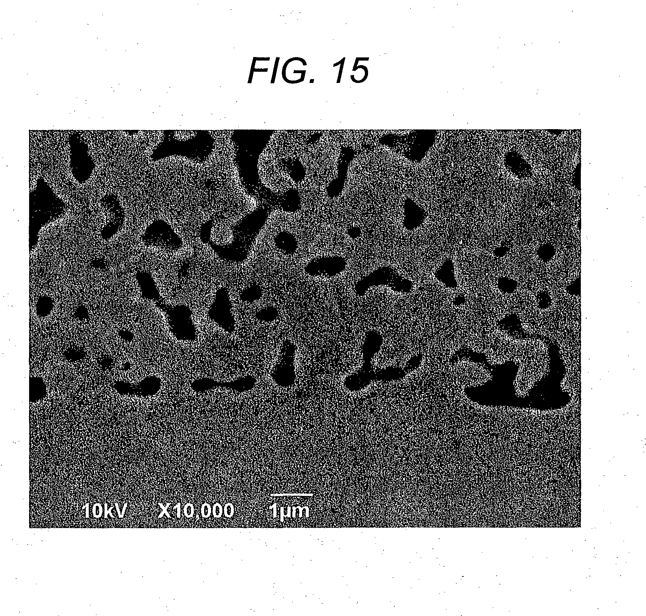

As shown in Table 1, an extremely high bonding strength of 40 MPa or more was obtained in a case of using the specimens 1 to 2 in which the oxidation could be suppressed. This is considered to be attributable to that the oxidation of the copper nanoparticles was suppressed in the specimens 1 to 2. The bonding layer has a porous structure as shown in SEM image of Fig. 15. (Relation between specific surface area and bonding strength)

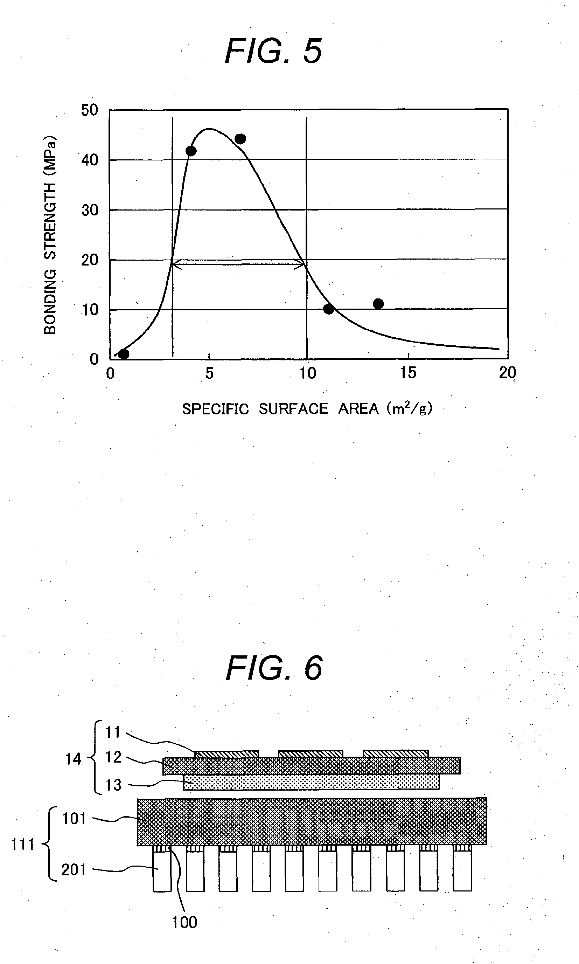

Table 1 shows the result of measuring the bonding strength in the specimens 1 to 2 and Comparative Examples 1 to 3 together. Fig. 5 shows a relation between the specific surface area and the bonding strength.

In view of Fig. 5, it can be seen that the bonding strength is extremely high in a range of the specific surface area of 5 to 10 m²/g.

### (Bondability to dissimilar metal)

Usefulness of incorporation of copper nanoparticles of 35 nm or less was confirmed by evaluating the bondability to Ni. In the test, a lower test specimen of 10 mm diameter and 5 mm thickness and an upper test specimen of 5 mm diameter and 2 mm thickness applied with 1 µm Ni plating were used. The bonding conditions were identical with those of the method described in the paragraph of (bonding strength test of sinterable bonding material). The result of this experiment was also described in Table 1. As shown in Table 1, when specimens 1 to 2 containing particles of 35 nm or less were used, extremely high bonding strength of 25 MPa or more was obtained. On the other hand, the strength was low in Comparative Examples 1 to 3. It is considered to be attributable to that the oxidation of the particles could not be suppressed in Comparative Example 1, the particle was somewhat larger as 50 nm in Comparative Example 2, and the particle was extremely large as 1 µm in Comparative Example 3. As described above, it was shown that the particles having a particle diameter of 35 nm were important in the bonding with the dissimilar material. This is because particles of high surface energy have to be used for attaining the bonding with the dissimilar metal.

### [Example 3]

### (Application to cooling unit)

Description is to be made to an example of using a sinterable bonding material of the present invention for pin connection of a pin fin cooling unit of a semiconductor power module.

In the semiconductor power module, since the amount of heat generation have tended to be increased in recent years, a technique of efficiently dissipating the heat generated during operation to the outside of the module has become important more and more.

Fig. 6 is a schematic cross sectional view showing an example of a wiring substrate and a pin fin cooling unit used in a semiconductor power module.

As shown in the drawing, a wiring substrate 14 has a structure of stacking a circuit wiring 11 to be connected with a semiconductor chip, an insulation substrate 12 for electrically insulating a semiconductor chip and the circuit wiring 11 in the inside of a module, and a metallized layer 13 for soldering the insulation substrate 12 and the pin fin cooling unit 111 to a metal support plate 101. Further, the pin fin cooling unit 111 has a structure in which a plurality of pin fins 201 are bonded by way of a bonding layer 100 to the metal support plate 101. Heat generated in the semiconductor power module is conducted in the direction of the thickness of the wiring substrate 14 and dissipated finally by way of the pin fins 201 attached to the metal support plate 101.

The metal support plate 101 and the pin fins 201 of the pin fin cooling unit 111 usually are made of copper. The metal support plate 101 and the pin fins 201 were bonded so far by using a silver brazing material at a temperature of 800°C or higher. Therefore, there was a problem that the metal support plate 101 and the pin fins 201 were softened to lower the mechanical strength and tended to be deformed.

Then, the metal support plate 101 and the pin fins 201 were bonded by using the sinterable bonding material in which the specimen 1 of Example 1 was dispersed in water. A sintering heat treatment was performed in hydrogen at a temperature of 400°C while applying a pressure of 1.2 MPa.

As a result, bonding at a temperature lower than the softening temperature of copper is possible and the problem of softening of copper could be solved.

### [Example 4]

### (Application to semiconductor device)

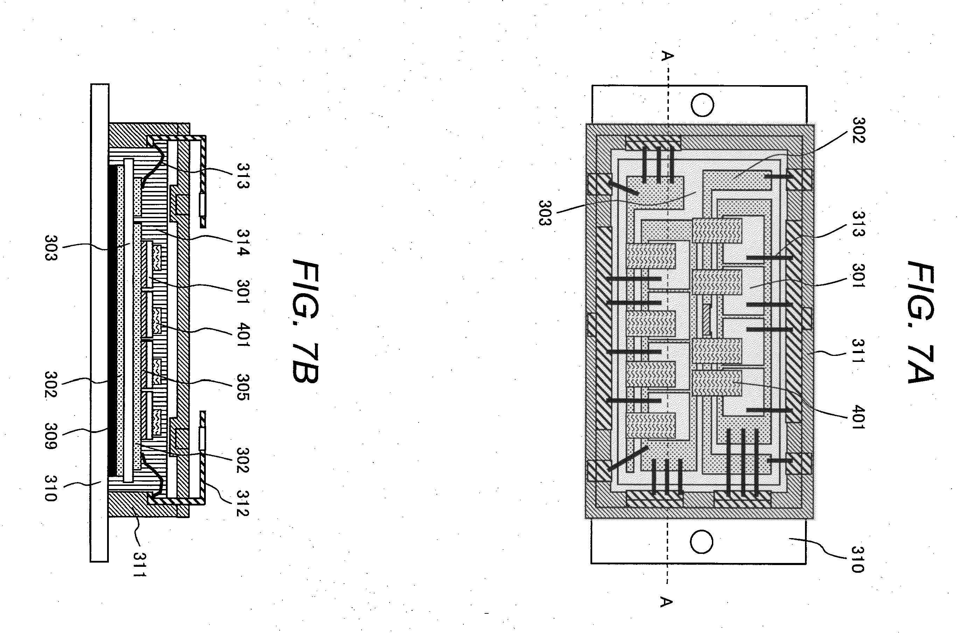

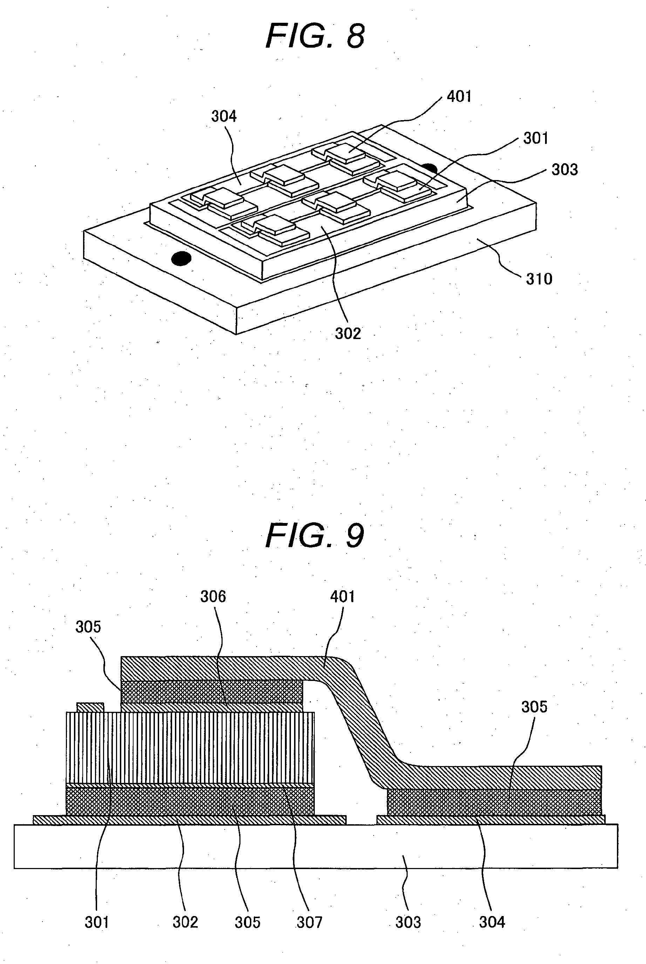

Fig. 7A is a plan view showing an insulated type semiconductor device to which the present invention is applied, and Fig. 7B is a cross sectional view along line A-A in Fig. 7A. Fig. 8 is a perspective view showing the insulated type semiconductor device in Fig. 7A. Fig. 9 is an enlarged cross sectional view showing a portion in which the semiconductor device of Fig. 8 is disposed.

Description is to be made with reference to Fig. 7A to Fig. 9.

A wiring substrate including a ceramic insulated substrate 303 and a wiring layer 302 is bonded by way of a solder layer 309 to a support member 310. The wiring layer 302 is formed of a nickel-plated copper wiring.

As shown in Fig. 9, a collector electrode 307 of a semiconductor device 301 and a wiring layer 302 over a ceramic insulation substrate 303 are bonded by way of a bonding layer 305. The bonding layer 305 is formed by using the sinterable bonding material prepared at 20°C in Example 1 and formed as a pure copper layer after bonding. Further, an emitter electrode 306 of the semiconductor device 301 and a connection terminal 401, and a connection terminal 401 and a wiring layer 304 over the ceramic insulation substrate 303 are also bonded by the bonding layer 305.

The bonding layer 305 has 80 µm thickness. Nickel plating is applied to the surface of the collector electrode 307 and the surface of the emitter electrode 306. That is, the surface of the collector electrode 307 and the surface of the emitter electrode 30 6 are covered with a nickel plating layer. Further, the connection terminals 401 include Cu or a Cu alloy.

The semiconductor device shown in Fig. 8 is contained in a casing 311 having external terminals 312 and covered with a sealant 314 as shown in Fig. 7B. The wiring layer 302 and the external terminals 312 are connected by means of bonding wires 313.

When the bonding layers 305 are formed, a sinterable bonding material containing 90 mass% of copper nanoparticles and 10 mass% of water is coated on one surface or both surfaces of a bonding surface of components to be bonded and dried at 80°C for one hour. Then, a sintering heat treatment is applied in hydrogen at 350°C for one minute under a pressure of 1.0 MPa. Supersonic vibrations may also be applied upon bonding. The bonding layers 305 may be formed individually or simultaneously.

The bonding layer 305 has a porous structure as shown in Fig. 15.

### [Example 5]

### (Application to multilayer wiring substrate)

In this example, application of the present invention to a part built-in type multilayer wiring substrate is to be described.

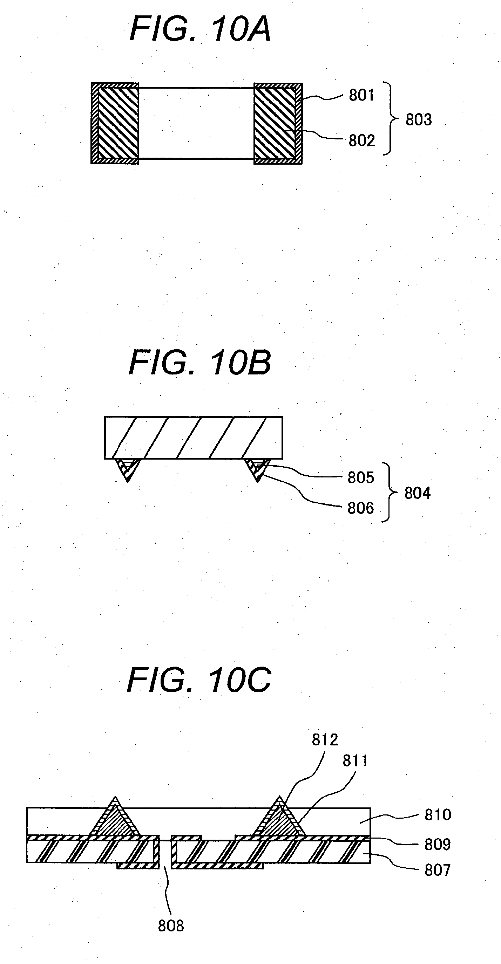

Fig. 10A is a cross sectional view of a capacitor which is incorporated in a part built-in type multilayer wiring substrate.

In a capacitor 803, a metallized layer 802 is formed as an electrode and a copper plating layer 801 is formed to the outer layer of the metallized layer 802.

Fig. 10B is a cross sectional view of an LSI chip incorporating a part built-in type multilayer wiring substrate.

In an LSI chip 804, a bump 805 is disposed on an electrode and a copper plating layer 806 is formed to the outer layer of the bump 805.

Fig. 10C is a cross sectional view for a portion of a core layer of a part built-in type multilayer wiring substrate.

Electric conduction in the direction of the thickness of a core 807 is established by a surface wiring 809 in a through hole 808. Electric conduction in the direction of the thickness of a prepreg 810 is established by a bump-like through electrode 812 having a copper plating layer 811 on the surface. A copper plating layer 811 may also be disposed to the surface of the surface wiring 809.

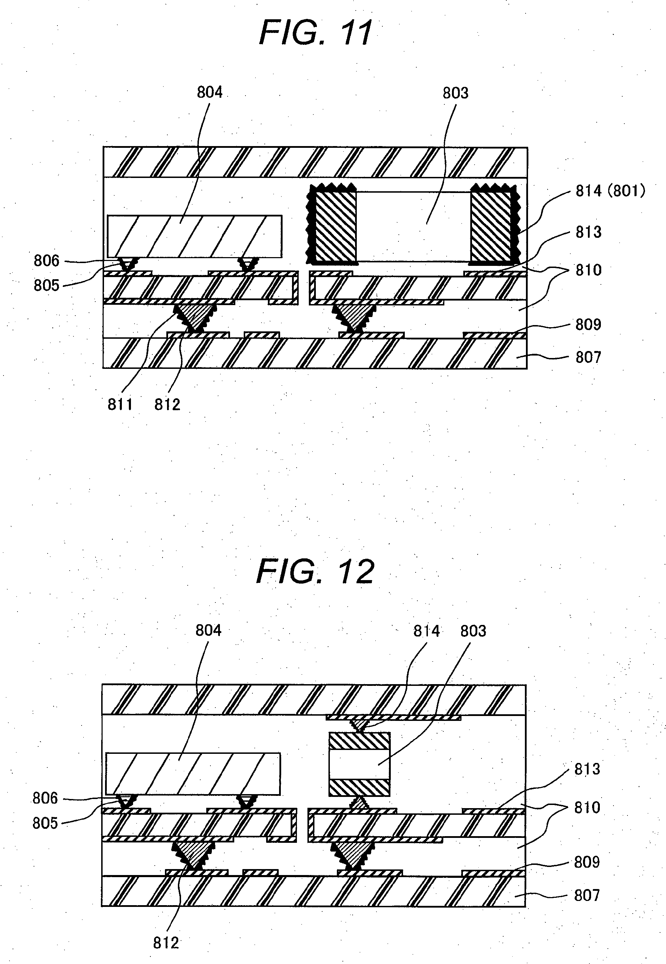

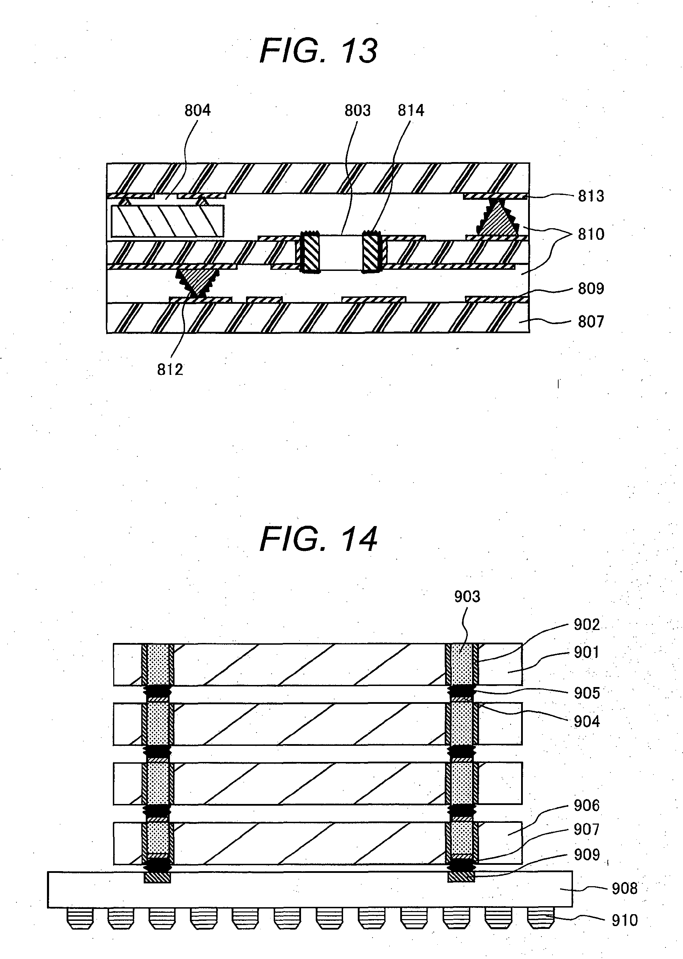

Fig. 11 is a cross sectional view showing an example of a part built-in type multilayer wiring substrate to which the present invention is applied. Fig. 12 is a cross sectional view showing another example of a part built-in type multilayer wiring substrate to which the present invention is applied. Fig. 13 is a cross sectional view showing a further example of a part built-in type multilayer wiring substrate to which the present invention is applied.

The capacitor 803, the LSI chip 804, the through electrode 812, and the surface wiring 809 shown in the drawings have copper plating layers 801 and 806, and 811 as respective bonding portions of them. After coating and drying the sinterable bonding material according to the present invention on the surface of the copper plating layers 801 and 806, and 811, a sintering heat treatment was applied in a formic acid atmosphere to form sintered copper layers 813 and 814. Bondings are performed respectively by way of the sintered copper layers 813 and 814. The surface of the sintered copper layers 813 and 814 other than the portions having a direct concern with the bonding are covered with a prepreg 810.

In the part built-in type multilayer wiring substrate to which the present invention is applied, since the projection area of the stacked wiring substrate can be minimized or the thickness thereof can be minimized by connecting the electronic part (for example, capacitor 803) in a vertical direction as shown in Fig. 12, or by connecting the same in a horizontal direction as shown in Fig. 13, high degree of freedom is attained in the design. Further, since the sintered copper layer 813 formed by using the sinterable bonding material according to the present invention has a small thickness, bonding is obtained while suppressing delay in electric signals.

### [Example 6]

### (Application to stacked chip)

In this example, application of the present invention to a stacked chip is to be described.

Fig. 14 is a cross sectional view showing an example of a stacked chip to which the present invention is applied.

In a semiconductor element 901, a through electrode 903 is formed by way of an insulation layer 902. A copper metallized layer 904 is disposed to one surface of the through electrode 903 and, after coating and drying the sinterable bonding material according to the present invention on the metallized layer 904, a sintering heat treatment is applied in hydrogen at 300°C to form a bonding layer 905 made of sintered copper. A plurality of semiconductor elements are stacked each by way of the bonding layer 905.

When the material of the through electrode 903 is not copper (for example, aluminum) bonding using the sinterable bonding material according to the present invention is possible by forming a nickel plating layer to the surface of the through electrode 903 and then forming a copper plating layer thereon. In the semiconductor element 906, a copper metallized layer 907 is formed on both surfaces of the through electrode 903 by such a double plating structure. A bonding layer 905 using the sinterable bonding material according to the present invention is formed to the surface of the copper metallized layer 907, and the stacked chip and the electrode 909 of an interposer 908 are connected electrically by way of the bonding layer 905. Bonding with the interposer 908 may also be done by brazing or press bonding. Further, the method of the present invention or an existent bonding method may be applied also for the bonding between bumps 910 disposed to the interposer 908 and the circuit substrate.

Features, components and specific details of the structures of the above-described examples may be exchanged or combined to form further examples optimized for the respective application. As far as those modifications are readily apparent for an expert skilled in the art they shall be disclosed implicitly by the above description without specifying explicitly every possible combination, for the sake of conciseness of the present description.

## Claims

1. A sinterable bonding material which is a liquid or a paste containing copper nanoparticles (155, 156) having a particle diameter of 1000 nm or less,
wherein the copper nanoparticles (155, 156) include primary particles (155) and secondary particles (156),
**characterized in that**
each of the secondary particles (156) is a fused body of the primary particles (155),
the copper nanoparticles (155, 156) have one or more particle diameter peaks of a number-based grain size distribution within a class of particle diameter of 1 to 35 nm and within a class of particle diameter of more than 35 nm and 1000 nm or less respectively, and
the copper nanoparticles (155, 156) have a specific surface area of 3 to 10 m²/g.

2. The sinterable bonding material according to claim 1,
wherein the liquid is water or a mixed solution of water and an alcoholic solvent.

3. The sinterable bonding material according to any one of claims 1 to 2,
wherein the content of the copper nanoparticles (155, 156) is 80 mass% or more.

4. The sinterable bonding material according to any one of claims 1 to 3,
further containing a dispersion stabilizer.

5. The sinterable bonding material according to claim 4,
wherein the content of the dispersion stabilizer is 30 mass parts or less based on 100 mass parts of copper that is a constituent of the copper nanoparticles (155, 156).

6. The sinterable bonding material according to claim 4 or 5,
wherein the dispersionstabilizer is sodium dodecyl sulfate, cetyl trimethyl ammonium chloride, citric acid, ethylenediamine tetraacetic acid, sodium bis(2-ethylhexyl) sulfonate, cetyl trimethyl ammonium bromide, polyvinyl pyrrolidone, polyacrylic acid, polyvinyl alcohol, or polyethylene glycol.

7. A process for producing a sinterable bonding material, the process comprising the steps of:
dissolving a copper compound in the liquid to form copper ions first;
adding an alkaline solution while flowing an inert gas in the liquid containing the copper ions to form a colloidal cupric oxide second;
adding a dispersion stabilizer to the liquid third; and
adding a reducing agent to the liquid containing the colloidal cupric oxide in a state of mixing the dispersion stabilizer to thereby form the copper nanoparticles (155, 156),
wherein the sinterable bonding material is a liquid containing copper nanoparticles (155, 156) having a particle diameter of 1000 nm or less,
wherein the copper nanoparticles (155, 156) include primary particles (155) and secondary particles (156),
**characterized in that**
each of the secondary particles (156) is a fused body of the primary particles (155),
the copper nanoparticles (155, 156) have one or more particle diameter peaks of a number-based particle diameter distribution within a class of particle diameter of 1 to 35 nm and within a class of the particle diameter of more than 35 nm and 1000 nm or less respectively, have a specific surface area of 3 to 10 m²/g, and are dispersed in the liquid.

8. The process according to claim 7,
wherein the copper compound includes at least one of a cupric nitrate hydrate, a cupric oxide and a cupric carboxylate.

9. The process according to claim 7 or 8, further comprising the steps of:
drying the liquid containing the copper nanoparticles (155, 156); and
dispersing the copper nanoparticles (155, 156) in a dispersing medium to thereby form them into a pasty form.

10. A method of bonding a plurality of electronic components, the method comprising the steps of:
coating the sinterable bonding material according to any one of claims 1 to 6 to one surface or both surfaces of a portion to be bonded; and
applying a sintering heat treatment in a reducing atmosphere at a temperature of 100 to 500°C.

11. The method according to claim 10,
wherein the reducing atmosphere is an atmosphere of hydrogen, formic acid or ethanol; and/or
wherein the sintering heat treatment isappliedwhilepressing the electronic components in a direction of the bonding.

12. The method according to claim 11,
wherein the electronic components are a chip and a wiring substrate of a semiconductor device (301); or
wherein the electronic components are cooling fins (201) and a metal support plate (101) of a cooling unit.

13. A semiconductor device comprising:
a connection terminal (401) including copper or a copper alloy;
a semiconductor element having an electrode (306), and
a bonding layer (305) made of the sinterable bonding material according to any one of claims 1 to 6 disposed between the connection terminal (401) and the electrode (306),
**characterized in that**
the surface of the electrode (306) is covered with a nickel plating layer.

14. The semiconductor device according to claim 13,
wherein the bonding layer (305) has a porous structure and has a bonding strength of 25 MPa or more.

## Patentansprüche

1. Sinterfähiges Bindungsmaterial, das eine Flüssigkeit oder eine Paste ist, die Kupfer-Nanopartikel (155, 156) mit einem Partikeldurchmesser von 1000 nm oder weniger enthält,
wobei die Kupfer-Nanopartikel (155, 156) primäre Partikel (155) und sekundäre Partikel (156) umfassen,
**dadurch gekennzeichnet, dass**
jedes der sekundären Partikel (156) ein verschmolzener Körper aus den primären Partikeln (155) ist,
die Kupfer-Nanopartikel (155, 156) jeweils eine oder mehrere Partikeldurchmesserspitzen einer anzahlbasierten Korngrößenverteilung innerhalb einer Klasse von Partikeldurchmessern im Bereich von 1 nm bis 35 nm und innerhalb einer Klasse von Partikeldurchmessern im Bereich von 35 nm bis 1000 nm aufweisen, und
die Kupfer-Nanopartikel (155, 156) einen spezifischen Oberflächeninhalt von 3 bis 10 m²/g aufweisen.

2. Sinterfähiges Bindungsmaterial nach Anspruch 1,
wobei die Flüssigkeit Wasser oder eine gemischte Lösung aus Wasser und einem alkoholischen Lösungsmittel ist.

3. Sinterfähiges Bindungsmaterial nach einem der Ansprüche 1 bis 2,
wobei der Gehalt der Kupfer-Nanopartikel (155, 156) 80 Massenprozent oder mehr beträgt.

4. Sinterfähiges Bindungsmaterial nach einem der Ansprüche 1 bis 3,
das ferner einen Dispersionsstabilisator enthält.

5. Sinterfähiges Bindungsmaterial nach Anspruch 4,
wobei der Gehalt des Dispersionsstabilisators 30 Massenteile oder weniger auf 100 Massenteile Kupfer, das ein Bestandteil der Kupfer-Nanopartikel (155, 156) ist, beträgt.

6. Sinterfähiges Bindungsmaterial nach Anspruch 4 oder 5,
wobei der Dispersionsstabilisator Natriumdodecylsulfat, Cetyltrimethylammoniumchlorid, Zitronensäure, Ethylendiamintetraessigsäure, Natrium-bis(2-ethylhexyl)-sulfonat, Cetyltrimethylammoniumbromid, Polyvinylpyrrolidon, Polyacrylsäure, Polyvinylalkohol oder Polyethylenglykol ist.

7. Prozess zum Herstellen eines sinterfähigen Bindungsmaterials, wobei der Prozess die folgenden Schritte umfasst:
Lösen einer Kupferverbindung in der Flüssigkeit, um als erstes Kupferionen zu bilden;
Zugeben einer alkalischen Lösung, während ein inertes Gas in die Flüssigkeit, die die Kupferionen enthält, geleitet wird, um als zweites ein kolloidales Kupfer(II)-oxid zu bilden;
Zugeben, als drittes, eines Dispersionsstabilisators zu der Flüssigkeit; und
Zugeben eines Reduktionsmittels zu der Flüssigkeit, die das kolloidale Kupfer(II)-oxid enthält, in einem Zustand der Vermischung mit dem Dispersionsstabilisator, um dadurch die Kupfer-Nanopartikel (155, 156) zu bilden,
wobei das sinterfähige Bindungsmaterial eine Flüssigkeit oder eine Paste ist, die Kupfer-Nanopartikel (155, 156) mit einem Partikeldurchmesser von 1000 nm oder weniger enthält,
wobei die Kupfer-Nanopartikel (155, 156) primäre Partikel (155) und sekundäre Partikel (156) umfassen,
**dadurch gekennzeichnet, dass**
jedes der sekundären Partikel (156) ein verschmolzener Körper aus den primären Partikeln (155) ist,
die Kupfer-Nanopartikel (155, 156) jeweils eine oder mehrere Partikeldurchmesserspitzen einer anzahlbasierten Korngrößenverteilung innerhalb einer Klasse von Partikeldurchmessern im Bereich von 1 nm bis 35 nm und innerhalb einer Klasse von Partikeldurchmessern im Bereich von 35 nm bis 1000 nm aufweisen, einen spezifischen Oberflächeninhalt von 3 bis 10 m²/g aufweisen und in der Flüssigkeit dispergiert sind.

8. Prozess nach Anspruch 7,
wobei die Kupferverbindung Kupfer(II)-nitrat-hydrat und/oder ein Kupfer(II)-oxid und und/ oder ein Kupfer(II)-carboxylat umfasst.

9. Prozess nach Anspruch 7 oder 8, der ferner die folgenden Schritte umfasst:
Trocknen der Flüssigkeit, die die Kupfer-Nanopartikel (155, 156) enthält; und
Dispergieren der Kupfer-Nanopartikel (155, 156) in einem Dispersionsmedium, um sie dadurch in eine pastöse Form zu bringen.

10. Verfahren zum Verbinden mehrerer elektronischer Komponenten, wobei das Verfahren die folgenden Schritte umfasst:
Beschichten einer Oberfläche oder beider Oberflächen eines Abschnitts, der verbunden werden soll, mit dem sinterfähigen Bindungsmaterial nach einem der Ansprüche 1 bis 6; und
Anwenden einer Sinterwärmebehandlung in einer reduzierenden Atmosphäre bei einer Temperatur im Bereich von 100 bis 500 °C.

11. Verfahren nach Anspruch 10,
wobei die reduzierende Atmosphäre eine Atmosphäre aus Wasserstoff, Ameisensäure oder Ethanol ist; und/oder
wobei die Sinterwärmebehandlung angewendet wird, während Druck auf die elektronischen Komponenten in einer Richtung der Verbindung ausgeübt wird.

12. Verfahren nach Anspruch 11,
wobei die elektronischen Komponenten ein Chip und ein Verdrahtungssubstrat einer Halbleitervorrichtung (301) sind; oder
wobei die elektronischen Komponenten Kühllamellen (201) und eine Metallträgerplatte (101) einer Kühleinheit sind.

13. Halbleitervorrichtung, die umfasst:
einen Verbindungsanschluss (401), der Kupfer oder eine Kupferlegierung enthält;
ein Halbleiterelement mit einer Elektrode (306); und
eine Bindungsschicht (305), die aus dem sinterfähigen Bindungsmaterial nach einem der Ansprüche 1 bis 6 hergestellt ist und zwischen dem Verbindungsanschluss (401) und der Elektrode (306) angeordnet ist,
**dadurch gekennzeichnet, dass**
die Oberfläche der Elektrode (306) mit einer nickelplattierten Schicht überzogen ist.

14. Halbleitervorrichtung nach Anspruch 13,
wobei die Bindungsschicht (305) eine poröse Struktur hat und eine Bindefestigkeit von 25 MPa oder mehr aufweist.

## Revendications

1. Matériau de liaison capable d'être fritté qui est un liquide ou une pâte contenant des nanoparticules de cuivre (155, 156) ayant un diamètre de particules de 1000 nm ou moins,
dans lequel les nanoparticules de cuivre (155, 156) incluent des particules primaires (155) et des particules secondaires (156),
**caractérisé en ce que**
chacune des particules secondaires (156) est un corps fusionné de particules primaires (155),
les nanoparticles de cuivre (155, 156) ont un ou plusieurs pics de diamètres de particules d'une distribution de tailles de grains basée sur des nombres à l'intérieur d'une classe de diamètre de particules de 1 à 35 nm et d'une classe de diamètre de particules plus grand que 35 nm et de 1000 nm ou moins, respectivement, et
les nanoparticules de cuivre (155, 156) ont une aire de surface spécifique de 3 à 10 m²/g.

2. Matériau de liaison capable d'être fritté selon la revendication 1,
dans lequel le liquide est de l'eau ou une solution mélangée d'eau et d'un solvant alcoolique.

3. Matériau de liaison capable d'être fritté selon l'une quelconque des revendications 1 et 2,
dans lequel la teneur des nanoparticules de cuivre (155, 156) est de 80 % en masse ou plus.

4. Matériau de liaison capable d'être fritté selon l'une quelconque des revendications 1 à 3,
comprenant en outre un stabilisateur de dispersion.

5. Matériau de liaison capable d'être fritté selon la revendication 4, dans lequel la teneur du stabilisateur de dispersion est de 30 parties en masse ou moins, basée sur 100 parties en masse de cuivre qui est un élément constitutif des nanoparticules de cuivre (155, 156).

6. Matériau de liaison capable d'être fritté selon la revendication 4 ou 5, dans lequel le stabilisateur de dispersion est du sulfate de sodium dodécyle, chlorure cétyle triméthyle ammonium, acide citrique, acide tétraacétique éthylène diamine, sodium bis(2-éthyle-hexyle) sulfonate, bromure de cétyle triméthyle ammonium, polyvinyle pyrrolidone, acide polyacrylique, alcool polyvinylique ou polyéthylène glycol.

7. Procédé pour produire un matériau de liaison capable d'être fritté,
le procédé comprenant les étapes consistant à :
dissoudre un composé à base de cuivre dans le liquide pour former des ions cuivre en premier lieu ;
ajouter une solution alcaline tout en amenant un gaz inerte à s'écouler dans le liquide contenant les ions cuivre pour former un oxyde de cuivre colloïdal en second lieu ;
ajouter un stabilisateur de dispersion au liquide en troisième lieu ; et
ajouter un agent réducteur au liquide contenant l'oxyde de cuivre colloïdal dans un état dans lequel on mélange le stabilisateur de dispersion pour former ainsi les nanoparticules de cuivre (155, 156),
dans lequel le matériau de liaison capable d'être fritté est un liquide contenant des nanoparticules de cuivre (155, 156) ayant un diamètre de particules de 1000 nm ou moins ; dans lequel les nanoparticules de cuivre (155, 156) incluent des particules primaires (155) et des particules secondaires (156),
**caractérisé en ce que**
chacune des particules secondaires (156) est un corps fusionné de particules primaires (155), les nanoparticules de cuivre (155, 156) ont un ou plusieurs pics de diamètre de particules d'une distribution de
diamètre de particules basée sur des nombres à l'intérieur d'une classe de diamètre de particules de 1 à 35 nm et d'une classe de diamètre de particules plus grandes que 35 nm et de 1000 nm ou moins, respectivement, elles ont une aire de surface spécifique de 3 à 10 m²/g, et elles sont dispersées dans le liquide.

8. Procédé selon la revendication 7;
dans lequel le composé à base de cuivre inclut au moins un élément parmi un hydrate de nitrate de cuivre, un oxyde de cuivre et un carboxylate de cuivre.

9. Procédé selon la revendication 7 ou 8, comprenant en outre les étapes consistant à :
faire sécher le liquide contenant les nanoparticules de cuivre (155, 156) ; et
faire disperser les nanoparticules de cuivre (155, 156) dans un milieu de dispersion pour les former ainsi sous une forme pâteuse.

10. Procédé pour faire la liaison d'une pluralité de composants électroniques, le procédé comprenant les étapes consistant à :
revêtir le matériau de liaison capable d'être fritté selon l'une des revendications 1 à 6 sur une surface ou sur les deux surfaces d'une portion à relier ; et
appliquer un traitement thermique de frittage dans une atmosphère réductrice à une température de 100 à 500° C.

11. Procédé selon la revendication 10,
dans lequel l'atmosphère réductrice est une atmosphère d'hydrogène, d'acide formique ou d'éthanol ; et/ou
dans lequel le traitement thermique de frittage est appliqué tout en pressant les composants électroniques dans la direction de la liaison.

12. Procédé selon la revendication 11,
dans lequel les composants électroniques sont une puce et un substrat de câblage d'un dispositif à semi-conducteur (301) ; ou
dans lequel les composants électroniques sont des ailettes de refroidissement (201) et une plaque de support en métal (101) d'une unité de refroidissement.

13. Dispositif semi-conducteur comprenant :
une borne de connexion (401) incluant du cuivre ou un alliage de cuivre ;
un élément semi-conducteur ayant une électrode (306), et
une couche de liaison (305) faite d'un matériau de liaison capable d'être fritté selon l'une quelconque des revendications 1 à 6, disposée entre la borne de connexion (401) et l'électrode (306),
**caractérisé en ce que**
la surface de l'électrode (306) est couverte avec une couche de placage au nickel.

14. Dispositif semi-conducteur selon la revendication 13,
dans lequel la couche de liaison (305) a une structure poreuse et une force de liaison de 25 MPa ou plus.
